# EUROPEAN PATENT SPECIFICATION

(11) **EP 3 951 853 B1**
(45) Date of publication and mention of the grant of the patent: **21.02.2024**
(21) Application number: 20782090.3
(22) Date of filing: 27.03.2020
(51) Int. Cl.: H01L 23/13, H01L 23/15, H01L 23/36, C04B 37/02, C04B 35/587, G01N 23/223

(54) **SILICON NITRIDE SUBSTRATE, SILICON NITRIDE-METAL COMPLEX, SILICON NITRIDE CIRCUIT BOARD, AND SEMICONDUCTOR PACKAGE**
SILICIUMNITRIDSUBSTRAT, SILIZIUMNITRID-METALL-KOMPLEX, SILICIUMNITRIDLEITERPLATTE UND HALBLEITERGEHÄUSE
SUBSTRAT DE NITRURE DE SILICIUM, COMPLEXE NITRURE DE SILICIUM-MÉTAL, CARTE DE CIRCUIT IMPRIMÉ EN NITRURE DE SILICIUM ET BOÎTIER SEMI-CONDUCTEUR

(30) Priority: 29.03.2019 JP 2019065541
(43) Date of publication of application: 09.02.2022
(73) Proprietor: Denka Company Limited, Tokyo 103-8338 (JP)
(72) Inventor: TSUGAWA, Yuta, Tokyo 103-8338 (JP); KOBASHI Seiji, Tokyo 103-8338 (JP); NISHIMURA Koji, Tokyo 103-8338 (JP)
(74) Representative: Gulde & Partner
(86) International application number: PCT/JP2020/014060
(87) International publication number: WO 2020/203787

(56) References cited:
- EP-A1- 0 766 307
- EP-A1- 3 061 739
- WO-A1-92/01654
- WO-A1-2013/146789
- WO-A1-2013/146789
- WO-A1-2017/014169
- WO-A1-2017/170247
- JP-A- 2009 215 142
- US-A- 4 285 895

## Description

### TECHNICAL FIELD

The present invention relates to a silicon nitride substrate, a silicon nitride-metal composite, a silicon nitride circuit board, and a semiconductor package.

### BACKGROUND ART

In recent years, a ceramic substrate, which is a ceramic sintered body, has been widely used as an insulating substrate constituting a circuit board or the like. For example, in manufacturing a power module, a ceramic circuit board obtained by bonding a metal circuit plate with a ceramic material such as alumina, beryllia, silicon nitride, or aluminum nitride has been used.

Further, recently, an amount of heat generated from the power module has been steadily increased in accordance with high power output or high integration of the power module. In order to efficiently dissipate the generated heat, a ceramic substrate such as a silicon nitride substrate or an aluminum nitride substrate having high insulation and high thermal conductivity tends to be used.

For example, Patent Document 1 discloses a technology relating to a method for producing a silicon nitride substrate in which a separation layer made of boron nitride in a specific composition is formed on a surface of a silicon nitride molded body in a process for producing the silicon nitride substrate. Further relevant examples of silicon nitride substrate in the prior art are disclosed in Patent Documents 2 to 4.

### RELATED DOCUMENT

### PATENT DOCUMENT

[Patent Document 1] Publication of International Patent Application WO 2013/054852 A1
[Patent Document 2] Publication of European Patent Application EP 0 766 307 A1
[Patent Document 3] Publication of European Patent Application EP 3 061 739 A1
[Patent Document 4] Publication of International Patent Application WO 2017/014169 A1

WO 2013/146789 A1 discloses a silicon nitride sintered substrate.

### SUMMARY OF THE INVENTION

### TECHNICAL PROBLEM

However, it has been difficult to obtain a highly reliable silicon nitride circuit board with a stable yield in the technology in the related art. One of the causes is warpage occurred in the silicon nitride substrate. Generally, when the large warpage of the silicon nitride substrate occurs, adhesion between a metal plate and the silicon nitride substrate is reduced, and in a temperature lowering process of a bonding step of bonding the metal plate and the silicon nitride substrate with a brazing material, or in a heat cycle when the power module is operated, the metal plate and the silicon nitride substrate are peeled off, resulting in poor bonding and poor thermal resistance, and a possibility of reducing reliability of a semiconductor package is thus increased.

Therefore, it is important to adjust the warpage of the silicon nitride substrate in an appropriate range from the viewpoint of improving a yield of the silicon nitride circuit board and improving the reliability. However, the warpage of the silicon nitride substrate may not be sufficiently suppressed in the technology in the related art.

The present invention has been made in view of such circumstances . The present invention is partly to provide a silicon nitride substrate with less warpage.

### SOLUTION TO PROBLEM

As a result of extensive studies, the present inventors have completed the invention which is set out in the appended set of claims and solved the above problems.

That is, according to the present invention, there is provided a silicon nitride substrate containing silicon nitride and magnesium,
in which the silicon nitride substrate has a rectangular shape and the diagonal on the surface of the silicon nitride substrate has a length of 150 mm or more, and in which when a surface of the silicon nitride substrate is analyzed with an X-ray fluorescence spectrometer under the following Condition I, XB/XA is 0.8 or more and 1.0 or less.

### (Condition I)

An amount of magnesium (% by mass, in terms of oxide) at an intersection A of diagonals on any one surface of the silicon nitride substrate is defined as XA (%), the amount of magnesium obtained by analyzing the intersection A with the X-ray fluorescence spectrometer. In addition, an arithmetic mean value of amounts of magnesium (% by mass, in terms of oxide) at four points of B1, B2, B3, and B4 which are on the diagonals and positioned 3 mm inward from corners of the silicon nitride substrate to a direction of the intersection A is defined as XB (%), the arithmetic mean value of the amounts of magnesium obtained by analyzing the four points B1, B2, B3, and B4 with the X-ray fluorescence spectrometer.

According to the present invention, there is provided a silicon nitride-metal composite in which a metal plate is bonded to at least one surface of the silicon nitride substrate.

According to the present invention, there is provided a silicon nitride circuit board in which at least a part of the metal plate is removed from the above silicon nitride-metal composite.

According to the present invention, there is provided a semiconductor package in which a semiconductor element is mounted on the above silicon nitride circuit board.

### ADVANTAGEOUS EFFECTS OF INVENTION

According to the present invention, it is possible to provide a silicon nitride substrate with reduced warpage, a silicon nitride circuit board, a silicon nitride-metal composite, and a semiconductor package.

### BRIEF DESCRIPTION OF THE DRAWINGS

[Fig. 1] A plan view schematically illustrating analysis parts according to the present embodiment when analyzing an amount of magnesium and an amount of yttrium in a silicon nitride substrate.
[Fig. 2] A plan view schematically illustrating analysis parts of an amount of oxygen in the silicon nitride substrate according to the present embodiment.
[Fig. 3] A cross-sectional view schematically illustrating a silicon nitride-metal composite according to the present embodiment.

### DESCRIPTION OF EMBODIMENTS

Hereinafter, an embodiment of the present invention will be described in detail with reference to the drawings.

In all drawings, the same constituent components are denoted by the same reference signs, and detailed explanation thereof will not be repeated.

In order to avoid complexity, in a case where there is a plurality of the same components in the same drawing, only one of the components is denoted by a reference sign, and all the components are not denoted by reference signs, or the same components may not be denoted by reference signs again.

All drawings are for illustration purposes only. The shapes, dimensional ratios, and the like of each part in the drawings do not necessarily correspond to actual articles. Specifically, vertical and horizontal dimensions of each part illustrated in the drawings may be exaggerated in a vertical or horizontal direction.

Unless otherwise specified, "P to Q" in the numerical range represents "P or more and Q or less".

First, a silicon nitride substrate according to the present embodiment will be described.

The silicon nitride substrate according to the present embodiment is a silicon nitride substrate containing silicon nitride and magnesium, and specifically, is formed of a sintered body including silicon nitride as a main component and grain boundary phases formed of a sintering aid containing magnesium. The "main component" is, as a guide, 80% by mass or more in the silicon nitride substrate, may be 85% by mass or more, or 90% by mass or more. In addition, components other than the main component are, specifically, compounds obtained by reacting the sintering aids with each other or impurities.

Further, the silicon nitride substrate according to the present embodiment has a specific plate shape, and includes a surface serving as a bonding surface with a plate-shaped metal. More specifically, a surface shape of the silicon nitride substrate is a rectangular shape having four corners and two diagonals.

When the silicon nitride substrate is analyzed with an X-ray fluorescence spectrometer under the following Condition I, XB/XA of the silicon nitride substrate according to the present embodiment is 0.80 or more and 1.00 or less, preferably 0.82 or more and 1.00 or less, and more preferably 0.90 or more and 1.00 or less.

### (Condition I)

An amount of magnesium (% by mass, in terms of oxide) at an intersection A of diagonals on any one surface of the silicon nitride substrate is defined as XA (%), the amount of magnesium obtained by analyzing the intersection A with the X-ray fluorescence spectrometer. In addition, an arithmetic mean value of amounts of magnesium (% by mass, in terms of oxide) at four points of B1, B2, B3, and B4 which are on the diagonals and positioned 3 mm inward from corners of the silicon nitride substrate to a direction of the intersection is defined as XB (%), the arithmetic mean value of the amounts of magnesium obtained by analyzing the four points B1, B2, B3, and B4 with the X-ray fluorescence spectrometer.

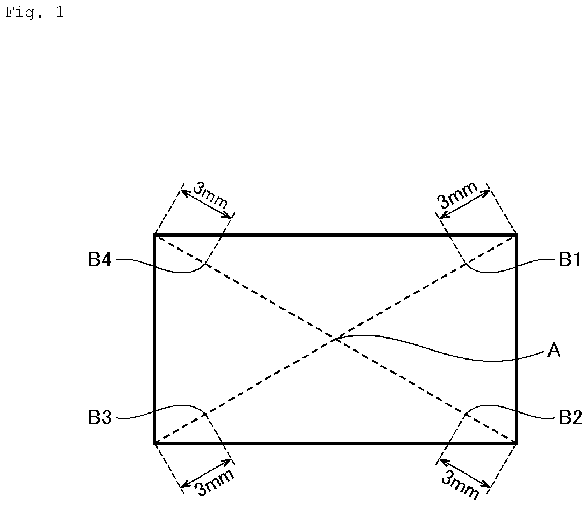

Analysis parts of Condition I will be described with reference to Fig. 1. Fig. 1 is a plan view schematically illustrating analysis parts of a silicon nitride substrate according to the present embodiment when analyzing an amount of magnesium and an amount of yttrium (to be described later) in the silicon nitride.

The silicon nitride substrate according to the present embodiment has a plate shape, and a rectangular shape. An intersection of two diagonals on any one surface of the silicon nitride substrate according to the present embodiment is defined as an intersection A, and an amount of magnesium (% by mass, in terms of oxide) measured with the X-ray fluorescence spectrometer while centering on the intersection A is defined as XA (%) . In addition, an amount of magnesium (% by mass, in terms of oxide) measured with the X-ray fluorescence spectrometer while centering on four points B1, B2, B3, and B4 is defined as XB1 (%), XB2 (%), XB3 (%), and XB4 (%), the four points B1, B2, B3, and B4 being positioned 3 mm inward from corners of the silicon nitride substrate to a direction of the intersection A and present on the two diagonals. Further, an arithmetic mean value of XB1 (%), XB2 (%), XB3 (%), and XB4 (%) is defined as XB (%).

Conditions of analysis by the x-ray fluorescence spectrometer may be as follows.
Measuring device: ZSX100e manufactured by Rigaku Corporation
X-ray tube power: 3.6 kW
Spot diameter: 1 mm

As a quantifying method, it is preferable to adopt a fundamental parameter (FP) method. In this case, assuming that all of silicon are present as nitride (Si₃N₄) , silicon nitride (Si₃N₄) is calculated as a balance component so that the total of each component is 100%. In addition, assuming that magnesium and yttrium are present as oxides, respectively, the magnesium and the yttrium are calculated in terms of magnesium oxide (MgO) and yttrium oxide (Y₂O₃) . It is also possible to calculate XB/XA directly from an intensity ratio of fluorescent X-rays of magnesium obtained by X-ray fluorescence analysis.

The reason why the silicon nitride substrate according to the present embodiment can reduce the warpage of the silicon nitride substrate by defining the amount of magnesium measured with the X-ray fluorescence spectrometer as described above is not necessarily clear, but is presumed as follows.

In a firing of the silicon nitride substrate, magnesium oxide which is a sintering aid and yttrium oxide react with silicon nitride and silicon oxide to form a liquid phase. Further, sintering of silicon nitride can be promoted by the liquid phase to obtain a dense silicon nitride sintered body. Therefore, the liquid phase formed of the sintering aid plays an important role in the sintering of the silicon nitride. However, the liquid phase may relatively easily move in the silicon nitride substrate, and thus the liquid phase may volatilize from an outer peripheral portion of the silicon nitride substrate to the outside of a silicon nitride substrate system in the firing or segregate in a specific portion in the silicon nitride substrate. Specifically, a liquid phase component containing magnesium oxide has a low melting point and contributes greatly to the promotion of sintering, but the liquid phase component is easy to move, and is likely to be distributed nonuniformly within the substrate.

The silicon nitride substrate having a nonuniform distribution of the aid components is a substrate having a portion with a large amount of aid components and a portion with a small amount of aid components, for example, different thermal expansion amounts in the outer peripheral portion or inside of the substrate, and therefore, it is presumed that a shrinkage difference is generated in a cooling process, and warpage is likely to occur.

Studies have been conducted focusing on a composition of the aid component or the like of the silicon nitride substrate, in the related art. Specifically, in the related art, studies focused on an aid present in a small part of a surface layer of the silicon nitride substrate (specifically, within several um from the surface of the silicon nitride substrate) have been conducted using, for example, an electron probe micro analyzer (EPMA) . However, for example, even if the technology in the related art is used in the silicon nitride substrate having a relatively large size, the warpage cannot be sufficiently stably reduced.

The present inventors have found that controlling the distribution of the aid components of the silicon nitride substrate from a macroscopic viewpoint is related to a higher degree of reduction of the warpage, thereby achieving the present embodiment.

That is, X-ray fluorescence analysis is an analysis method that can acquire information on the distribution of compositions at a deeper position than in a surface analysis method using various electron beams. For example, it can analyze the distribution of compositions present from the surface of the silicon nitride substrate to the depth of several tens of um to several mm. Therefore, defining the amount of magnesium measured with the X-ray fluorescence spectrometer defines a distribution of magnesium present in a bulk at a depth of several tens of um to several mm including the surface layer.

In addition, the present embodiment has a characteristic in that the analysis parts are specified at the outer peripheral portion of the silicon nitride substrate and the central portion of the silicon nitride substrate by the X-ray fluorescence analysis. That is, a plurality of silicon nitride substrates is generally stacked and fired from the viewpoint of reduction in manufacturing costs, and as described above, the liquid phase formed of magnesium oxide which is a sintering aid and yttrium oxide may volatilize during firing. According to the studies by the present inventors, it was found that, for example, when the plurality of stacked silicon nitride substrates are fired, the easiness of volatilization of the sintering aid at the central portion of the silicon nitride substrate and the easiness of volatilization of the sintering aid at the outer peripheral portion of the silicon nitride substrate differ from each other, whereas there is a tendency that, for example, magnesium oxide is most difficult to volatilize at the central portion of the silicon nitride substrate, and is most easy to volatile at the outer peripheral portion of the silicon nitride substrate. That is, by extensively studying the composition distribution of the bulk in the fired silicon nitride substrate and defining an amount of each component of the intersection A of the diagonals on any one surface of the silicon nitride substrate, and an amount of each component of the four points B1, B2, B3, and B4 which are on the diagonals and positioned within 3 mm from the corners of the silicon nitride substrate to the direction of the intersection A, the present inventors have considered that a portion where reproducibility is good and the distribution of the sintering aid of the silicon nitride substrate is maximum and a portion where the distribution of the sintering aid of the silicon nitride substrate is minimum can be grasped, thereby achieving the present embodiment.

According to the present embodiment, the type and amount of the components of a raw material of the silicon nitride substrate, and the manufacturing method thereof (specifically, temperature condition and atmosphere adjustment condition in firing method) are adjusted to specify the amount of aid components of the bulk at the central portion and outer peripheral portion of the obtained silicon nitride substrate, and in the macroscopic viewpoint that has not been focused in the related art, the distribution of aid components is made extremely uniform, such that it is presumed that the warpage can be stably reduced even in the silicon nitride substrate having a relatively large size, and the yield can be good and the warpage can be reduced even when the plurality of substrates are stacked and fired at the same time. Therefore, for example, when the metal plate is bonded to one surface of the silicon nitride substrate according to the present embodiment to obtain a silicon nitride-metal composite or when a silicon nitride circuit board is obtained from silicon nitride-metal composite and a semiconductor element or the like is mounted thereon, a semiconductor package with excellent reliability, such as bondability between the silicon nitride substrate and a metal circuit plate, can be obtained.

Further, according to the present embodiment, it is possible to obtain a silicon nitride substrate in which variations in characteristics of the silicon nitride substrate are decreased, and for example, it is possible to obtain a silicon nitride substrate in which an in-plane distribution with mechanical characteristics of a fracture toughness value is uniform.

The present embodiment is not limited by the presumed mechanism described above.

When the silicon nitride substrate is analyzed with an X-ray fluorescence spectrometer under the following Condition II, YB/YA of the silicon nitride substrate according to the present embodiment is preferably 0.90 or more and 1.00 or less, more preferably 0.94 or more and 1.00 or less, and still more preferably 0.97 or more and 1.00 or less.

### (Condition II)

An amount of yttrium (% by mass, in terms of oxide) at an intersection A of diagonals on any one surface of the silicon nitride substrate is defined as YA (%), the amount of yttrium obtained by analyzing the intersection A with the X-ray fluorescence spectrometer. In addition, an arithmetic mean value of amounts of yttrium (% by mass, in terms of oxide) at four points of B1, B2, B3, and B4 which are on the diagonals and positioned 3 mm inward from corners of the silicon nitride substrate to a direction of the intersection A is defined as YB (%), the arithmetic mean value of the amounts of yttrium obtained by analyzing the four points B1, B2, B3, and B4 with the X-ray fluorescence spectrometer.

The intersection A and the four points B1, B2, B3, and B4 which are positioned 3 mm inward from the corners of the silicon nitride substrate to the direction of the intersection A are the same as those of Condition I, the intersection A and the four points B1, B2, B3, and B4 being the analysis parts of Condition II. That is, an intersection of two diagonals on any one surface of the silicon nitride substrate according to the present embodiment is defined as an intersection A, and an amount of yttrium (% by mass, in terms of oxide) measured with the X-ray fluorescence spectrometer while centering on the intersection A is defined as YA (%) . In addition, an amount of yttrium (% by mass, in terms of oxide) measured with the X-ray fluorescence spectrometer while centering on four points B1, B2, B3, and B4 is defined as YB1 (%), YB2 (%), YB3 (%), and YB4 (%), the four points B1, B2, B3, and B4 being positioned 3 mm inward from corners of the silicon nitride substrate to a direction of the intersection A and present on the two diagonals. Further, an arithmetic mean value of YB1 (%), YB2 (%), YB3 (%), and YB4 (%) is defined as YB (%). Conditions of analysis by the X-ray fluorescence spectrometer are as described above.

By setting the amount of yttrium measured with X-ray fluorescence analysis within the above numerical range, it is considered that a silicon nitride substrate with less warpage can be obtained more stably, and the reliability and yield of the semiconductor package using the silicon nitride substrate can be improved.

In the silicon nitride substrate according to the present embodiment, XB/XA is within the above numerical range, in which when analyzed under Condition I, an amount of magnesium at the central portion of the silicon nitride substrate is defined as XA, and an amount of magnesium at the outer peripheral portion of the silicon nitride substrate is defined as XB, and an absolute value thereof is not limited. Each of XA and XB may be, for example, 0.1% by mass or more and 5% by mass or less, and more preferably 0.5% by mass or more and 3% by mass or less. In addition, each of XA and XB is, for example, 0.1% by mass or more, and preferably 0.5% by mass or more, and for example, 5% by mass or less, and preferably 3% by mass or less.

Further, in the silicon nitride substrate according to the present embodiment, YA/YB is preferably within the above numerical range, in which when analyzed under Condition II, an amount of yttrium at the central portion of the silicon nitride substrate is defined as YA, and an amount of yttrium at the outer peripheral portion of the silicon nitride substrate is defined as YB, and an absolute value thereof is not limited. Each of YA and YB may be, for example, 0.1% by mass or more and 10% by mass or less, and more preferably 1% by mass or more and 8% by mass or less. In addition, each of YA and YB is, for example, 0.1% by mass or more, and preferably 1% by mass or more, and for example, 10% by mass or less, and preferably 8% by mass or less.

In the silicon nitride substrate according to the present embodiment, XA/YA, which is a ratio between the amount of magnesium XA at the central portion of the silicon nitride substrate and the amount of yttrium YA at the central portion of the silicon nitride substrate, may be, for example, 0.05 or more, and preferably 0.1 or more, and for example, 0.7 or less, and preferably 0.5 or less . XB/YB, which is a ratio between the amount of magnesium XB at the outer peripheral portion of the silicon nitride substrate and the amount of yttrium YB at the central portion of the silicon nitride substrate may be, for example, 0.05 or more, and preferably 0.1 or more, and for example, 0.6 or less, and preferably 0.5 or less.

To give an example of a content of components other than the amount of magnesium and the amount of yttrium, when the components are analyzed, under the above conditions, with an X-ray fluorescence spectrometer while centering on the intersection A of the diagonals on any one surface of the silicon nitride substrate according to the present embodiment and the four points B1, B2, B3, and B4 which are positioned 3 mm inward from the corners of the silicon nitride substrate to the direction of the intersection A, an amount of silicon nitride (Si₃N₄) may be 80.0% by mass or more and 98.0% by mass or less, and more preferably 85.0% by mass or more and 95.0% by mass or less. In addition, the amount of silicon nitride is, for example, 80.0% by mass or more, and preferably 85.0% by mass or more, and for example, 98.0% by mass or less, and preferably 95.0% by mass or less. In addition, when the silicon nitride substrate includes other components except for silicon nitride (Si₃N₄), magnesium (in terms of oxide), and Yttrium (in terms of oxide), the amount of other components may be, for example, 0.10% by mass or more and 0.50% by mass or less.

When oxygen concentrations of the silicon nitride substrate according to the present embodiment are analyzed with an oxygen-nitrogen analyzer under the following Condition III, it is preferable that each of ZC and ZD is 0.10% or more and 7.00% or less, and ZD/ZC is 0.85 or more and 1.00 or less, it is more preferable that each of ZC and ZD are 2.00% or more and 5.00% or less, and ZD/ZC is 0.90% or more and 1.00 or less, and it is still more preferable that each of ZC and ZD are 2. 50% or more and 3.00% or less, and ZD/ZC is 0.93% or more and 1.00 or less.

When the oxygen concentrations are analyzed with an oxygen-nitrogen analyzer under the following Condition III, ZC and ZD are preferably 0.10% or more, more preferably 2.00% or more, and still more preferably 2.50% or more, and preferably 7.00% or less, more preferably 5.00% or less, and still more preferably 3.00% or less, respectively.

When the oxygen concentrations are analyzed with an oxygen-nitrogen analyzer under the following Condition III, ZD/ZC is preferably 0.85 or more, more preferably 0.90 or more, still more preferably 0.93 or more, and preferably 1.00 or less.

### (Condition III)

A square having a side of 3 mm centered on an intersection of diagonals on the surface of the silicon nitride substrate, specifically, on any one surface of the silicon nitride substrate under Conditions I and II, is cut out from the silicon nitride substrate, and is used as a sample C for oxygen analysis. The sample C for oxygen analysis is analyzed with an oxygen-nitrogen analyzer, and an oxygen concentration (% by mass) of the sample C for oxygen analysis is defined as ZC (%). In addition, a square having a side of 3 mm including any corner on the surface of the silicon nitride substrate is cut out from the silicon nitride substrate, and is used as a sample D for oxygen analysis. The sample D for oxygen analysis is analyzed with an oxygen-nitrogen analyzer, and an oxygen concentration (% by mass) of the sample D for oxygen analysis is defined as ZD (%).

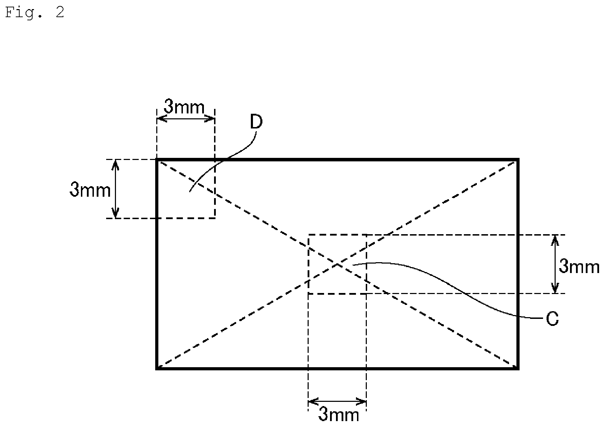

Analysis parts of Condition III will be described with reference to Fig. 2. Fig. 2 is a plan view schematically illustrating analysis parts of the silicon nitride substrate according to the present embodiment when analyzing an amount of oxygen in the silicon nitride substrate.

A square which centers on an intersection of diagonals on the main surface of the silicon nitride substrate according to the present embodiment and has a side of 3 mm, and, whose intersection point is at the intersection of diagonals is specified. The square may have sides parallel to the rectangular silicon nitride substrate. A sample C for oxygen analysis is obtainable by cutting out the square. The sample C for oxygen analysis is analyzed with an oxygen-nitrogen analyzer, and an oxygen concentration (% by mass) of the sample C for oxygen analysis is defined as ZC (%) . In addition, a square having a side of 3 mm including any of the corners (each apex when the rectangular silicon nitride substrate is viewed from above) from the silicon nitride substrate is specified. The square may have sides parallel to the rectangular silicon nitride substrate. A sample D for oxygen analysis obtainable by cutting out the square. The sample D for oxygen analysis is analyzed with an oxygen-nitrogen analyzer, and an oxygen concentration (% by mass) of the sample D for oxygen analysis is defined as ZD (%).

An example of the oxygen-nitrogen analyzer may include a device capable of measuring the oxygen concentration by an inert-gas melting-nondispersive infrared absorption method (NDIR), and specifically, EMGA-920 manufactured by HORIBA, Ltd.

Oxygen contained in the silicon nitride substrate is mainly caused by the aid component. Therefore, the concentration of oxygen present at the central portion of the silicon nitride substrate and the concentration of oxygen present at the outer peripheral portion of the silicon nitride substrate are set within the above numerical range, which means that a total of aid components containing magnesium, yttrium, and other components is uniformly distributed in the plane. According to the present embodiment, not only the distribution of each aid component is controlled to be uniform, but also the distribution of the aid components is as a whole controlled to be uniform, such that it is considered that a silicon nitride substrate with less warpage can be obtained more stably, and reliability and yield of the semiconductor package using the silicon nitride substrate can be further improved.

The silicon nitride substrate according to the present embodiment has a rectangular shape. In addition, a length of the diagonal on the surface of the silicon nitride substrate is 150 mm or more, preferably 200 mm or more, and more preferably 236 mm or more. The upper limit thereof is not limited, and may be, for example, 254 mm or less.

A thickness of the silicon nitride substrate according to the present embodiment may be 0.1 mm or more and 3.0 mm or less, preferably 0.2 mm or more and 1.2 mm or less, and more preferably 0.25 mm or more and 0.5 mm or less. In addition, the thickness of the silicon nitride substrate is, for example, 0.1 mm or more, preferably 0.2 mm or more, and more preferably 0.25 mm or more, and for example, 3.0 mm or less, preferably 1.2 mm or less, and more preferably 0.5 mm or less.

In the related art, the silicon nitride substrate having a relatively large size or the silicon nitride substrate having a relatively small thickness is difficult to obtain the stable yield due to reduction of warpage or the like. However, according to the silicon nitride substrate according to the present embodiment, even the silicon nitride substrate having a relatively large area or the silicon nitride substrate having a relatively small thickness can improve manufacturing stability.

The silicon nitride substrate according to the present embodiment preferably has warpage per unit length of less than 1.0 µm/mm.

The warpage may be measured by the method described in Examples.

The silicon nitride substrate according to the present embodiment has a fracture toughness value of preferably 6.5 MPa/m^{1/2} or more, and more preferably 6.6 MPa/m^{1/2} or more. The fracture toughness value of the silicon nitride substrate is not limited and may be, for example, 20 MPa/m^{1/2} or less.

Further, the silicon nitride substrate according to the present embodiment preferably has a uniform in-plane distribution of mechanical properties or the like. For example, when a fracture toughness value at a central portion of the substrate (region within a radius of 3 mm centered on the intersection of the diagonals) is defined as K_{ICI}, and a fracture toughness value at an outer peripheral portion of the substrate (region within a radius of 3 mm from a corner) is defined as K_{ICO}, K_{ICI}/K_{ICO} is preferably 0.90 or more and 1.10 or less, more preferably 0.95 or more and 1.05 or less, and still more preferably 0.97 or more and 1.03 or less. In addition, K_{ICI}/K_{ICO} is preferably 0.90 or more, more preferably 0.95 or more, and still more preferably 0.97 or more, and preferably 1.10 or less, more preferably 1.05 or less, and still more preferably 1.03 or less.

According to the silicon nitride substrate according to the present embodiment, even the silicon nitride substrate having a relatively large area can make the in-plan distribution of mechanical properties or the like uniform, and reliability and manufacturing stability can be further improved.

The fracture toughness can be measured by an IF method based on JIS-R1607.

### <Manufacturing Method of Silicon Nitride Substrate>

Hereinafter, a method of producing the silicon nitride substrate according to the present embodiment will be described.

### (Raw Material Mixing)

A raw material of the silicon nitride substrate specifically contains silicon nitride and a magnesium raw material, and the magnesium raw material is preferably blended as a sintering aid.

More specifically, first, silicon nitride (Si₃N₄) powder and sintering aid powder such as magnesium oxide (MgO) powder and silicon oxide (SiO₂) powder are prepared and wet-mixed with a solvent using a mixer such as a barrel mill, a rotary mill, a vibration mill, a bead mill, a sand mill, or an agitator mill, to prepare a slurry (raw material mixture).

A material produced by known methods such as a direct nitriding method, a silica reduction method, and an imide pyrolysis method may be used as the silicon nitride powder. The amount of oxygen in the silicon nitride powder is preferably 2% by mass or less, and more preferably 1.5% by mass or less. An average particle size (D50 value) of the silicon nitride powder is preferably 0.4 to 1.5 um, and more preferably 0.6 to 0.8 um. By setting the amount of oxygen and the average particle size (D50 value) of the silicon nitride powder within the above ranges, it is possible to reduce decreasing in density and mechanical strength of the silicon nitride sintered body.

For the silicon nitride substrate according to the present embodiment it is preferable to use SiO₂ powder as a part of a raw material thereof. Specifically, it is preferable that the sintering aid, which is the raw material of the silicon nitride substrate, contains SiO₂ as an essential component. The SiO₂ powder preferably has a purity of 98% or more and an average particle size of 0.1 um or more and 3.0 um or less.

The sintering aid preferably contains silicon oxide (SiO₂), magnesium oxide (MgO) , and yttrium oxide (Y₂O₃) , and may also contain other oxides. Examples of other oxides may include oxides of rare earth metals, for example, Sc₂O₃, La₂O₃, Ce₂O₃, Pr₆O₁₁, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃.

An average particle size of the sintering aid is preferably 0.1 um or more and 3.0 um or less.

Preferably, raw material powder is blended in an amount of 80 parts by mass or more and 98 parts by mass or less of the silicon nitride (Si₃N₄) powder, and 2 parts by mass or more and 20 parts by mass or less of the sintering aid powder, with respect to a total of 100 parts by mass of the silicon nitride (Si₃N₄) powder and the sintering aid powder. When the amount of the sintering aid powder is too small, a dense silicon nitride sintered body may not be obtained, on the other hand, when the amount of the sintering aid powder is too large, thermal conductivity of the silicon nitride sintered body may be decreased.

When silicon oxide, magnesium oxide, and yttrium oxide are used as the sintering aid, preferably, the raw material powder is blended in an amount of 80 parts by mass or more and 98 mass or less of the silicon nitride (Si₃N₄) powder, 0.1 parts by mass or more and 5 parts by mass or less of the silicon oxide powder, 0.1 parts by mass or more and 5 parts by mass or less of the magnesium oxide powder, and 0.1 parts by mass or more and 10 parts by mass or less of the yttrium oxide, and more preferably, the raw material powder is blended in an amount of 85 parts by mass or more and 95 mass or less of the silicon nitride (Si₃N₄) powder, 0.5 parts by mass or more and 3 parts by mass or less of the silicon oxide powder, 0.5 parts by mass or more and 3 parts by mass or less of the magnesium oxide, and 1 part by mass or more and 8 parts by mass or less of the yttrium oxide, with respect to the total of 100 parts by mass of the silicon nitride (Si₃N₄) powder and the sintering aid powder.

It is considered that YA/YB tends to be decreased by reducing the amount of yttrium oxide used. In addition, it is considered that ZD/ZC tends to be decreased by increasing the amount of silicon oxide used.

The raw material powder is mixed with an organic solvent, and furthermore, an organic binder, if necessary, to prepare a raw material mixture. As the organic solvent or the organic binder used for preparing the raw material mixture, known ones can be appropriately selected depending on a molding method. For example, in molding, when sheet molding is performed by a doctor blade method, a slurry for sheet molding may be prepared using an organic solvent such as toluene, ethanol, or butanol, or an organic binder such as butylmethacrylate, polyvinylbutyral, or polymethylmethacrylate.

An addition amount of the organic binder may be, for example, 3 parts by mass or more and 17 parts by mass or less with respect to a total of 100 parts by mass of the raw material powder. By setting the addition amount of the organic binder within the above numerical range, a shape of a molded body can be sufficiently maintained, such that multilayering can be performed to improve mass productivity, and voids in a degreased body become large after a degreasing, such that remaining of the voids can be reduced in the obtainable silicon nitride substrate.

### (Molding)

Next, a molding step of molding the raw material mixture is performed. The molding method of the raw material mixture is not limited, and the sheet molding methods such as a mold pressing method, a cold isostatic pressing (CIP) method, a doctor blade method, and a roll molding method can be applied, and the doctor blade method is preferable from the viewpoint of stable mass production of the molded body having a relatively small thickness. Furthermore, the molded sheet can be punched to obtain a sheet molded body having a desired size, if necessary. A shape of the sheet is not limited, and for example, a sheet molded body having a length of each side of 100 mm or more, a thickness of 0.2 mm or more and 2 mm or less may be used.

### (BN Application)

Subsequently, a BN application may be performed by applying BN to at least one surface of the obtained molded body, specifically, the sheet molded body. This step is mainly performed for the purpose of reducing a sticking of stacked silicon nitride substrates each other during a firing.

A method of applying BN is not limited, and for example, examples thereof may include a method of preparing a BN slurry including BN powder and an organic solvent, and spray applying the obtained BN slurry to one or both surfaces of the sheet molded body, a method of preparing a BN paste containing BN powder, an organic solvent, and an organic binder and screen printing the obtained BN paste to one or both surfaces of the sheet molded body.

By drying the sheet molded body applied with the BN slurry or BN paste, the sheet molded body coated with BN can be obtained.

### (Degreasing)

A degreasing of the molded body is preferably performed before the firing. For example, the organic binder which is mainly added for molding can be removed in the degreasing.

The degreasing can be performed in the air (atmosphere including oxygen), a non-oxidizing atmosphere such as a nitrogen atmosphere or an argon atmosphere, or vacuum, and is preferably performed in the air or vacuum.

A degreasing temperature and a degreasing time vary depending on a type of the organic binder added in the molding, and for example, the degreasing temperature may be 500°C or higher and 800 °C or lower and the degreasing time may be 1 hour or longer and 20 hours or shorter.

In the degreasing, the sheet molded body obtained in the previous step may be stacked and charged into a degreasing furnace. The number of stacked sheet molded bodies may be, for example, 10 or more and 100 or less. In addition, a load of 10 to 40 kPa is preferably applied during degreasing. The load within the above range is applied during degreasing, such that warpage and cracks of the ceramic substrate after the firing can be reduced.

### (Firing)

Subsequently, the obtained degreased body is fired in a firing furnace. The sintering aid powder becomes a liquid phase in the process of the firing, and a dense sintered body can thus be obtained through liquid phase reaction.

A firing temperature is preferably 1700°C or higher and 1900°C or lower, and a firing time is preferably 3 hours or longer and 10 hours or shorter.

Further, in cooling process after firing, a temperature lowering rate is preferably 4°C/min or lower, more preferably 2°C/min or lower, and still more preferably 1°C/min or lower, in a temperature range of a temperature range (specifically, 1400°C to 1600°C) or higher in which the sintering aid is formed to be a liquid phase, that is, a temperature range of 1400°C or higher.

By setting the firing temperature, the firing time, and the temperature lowering rate within the above numerical ranges, a silicon nitride substrate having excellent thermal properties, excellent mechanical properties, and a uniform aid distribution can be obtained.

In order to obtain the silicon nitride substrate according to the present embodiment, that is, the silicon nitride substrate in which the aid is uniformly dispersed in a plane, it is important to control the atmosphere in the firing.

In the firing, in order to reduce decomposition in the silicon nitride substrate, it is preferable to fire the silicon nitride substrate at 0.6 MPa or more in a non-oxidizing atmosphere such as nitrogen gas or argon gas.

A gas flow rate during firing may be, for example, 5 L/min or more and 200 L/min or less.

In the firing, the degreased body obtained in the previous step may be stacked and charged into the firing furnace.

The number of stacked degreased body may be, for example, 10 or more and 100 or less.

The stacked degreased body is preferably installed in a firing furnace in a state of being housed in a container formed of BN (hereinafter, referred to as BN container). The BN container is preferably formed of, for example, a plurality of members such as plates and frames, and has a structure capable of forming a closed space by combining the members.

A volume of the BN container may be, for example, 2,000 cm³ or more and 15,000 cm³ or less. A silicon nitride substrate (sintered body) for adjusting atmosphere is preferably installed in the BN container together with the degreased body. A weight of the silicon nitride substrate for adjusting atmosphere is preferably 2 parts by mass or more and 20 parts by mass or less, with respect to 100 parts by mass of a weight of degreased bodies housed in a single BN container.

Further, the silicon nitride substrate for adjusting atmosphere can be installed in a direction horizontal to or perpendicular to the degreased body, and is preferably installed in a direction at least perpendicular to the degreased body.

By appropriately adjusting a reduction atmosphere around the degreased body to be fired and atmosphere of the volatilized aid using the BN container and the silicon nitride substrate (sintered body) for adjusting atmosphere, it is presumed that distribution of the aid can be controlled, and a silicon nitride substrate with less warpage after firing or less deformation caused by being subjected to subsequent heat history.

### <Silicon Nitride-Metal Composite>

Next, a silicon nitride-metal composite according to the present embodiment will be described.

A metal plate can be bonded to at least one surface of the silicon nitride substrate according to the present embodiment to form a silicon nitride-metal composite.

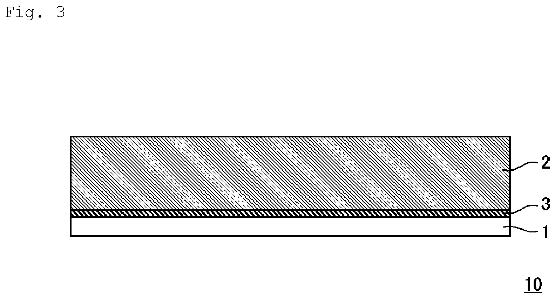

Fig. 3 is a cross-sectional view schematically illustrating a silicon nitride-metal composite according to the present embodiment.

The silicon nitride-metal composite 10 includes at least a silicon nitride substrate 1, a metal plate 2, and a brazing material layer 3 present between these two layers. In other words, the silicon nitride substrate 1 and the metal plate 2 are bonded by the brazing material layer 3.

### <Producing Method of Silicon Nitride-Metal Composite>

Hereinafter, a method of producing the silicon nitride-metal composite 10 will be described. The silicon nitride-metal composite 10 may be produced by, for example, the following steps.
(1) A brazing material paste is applied to one or both surfaces of the silicon nitride substrate 1 to bring the metal plate 2 into contact with the applied surface.
(2) The silicon nitride substrate 1 and the metal plate 2 are bonded by a heat treatment in a vacuum or inert atmosphere.

### (Metal Plate)

Examples of the metal that is used for the metal plate 2 used for the silicon nitride-metal composite 10 according to the present embodiment may include a single substance of copper, aluminum, iron, nickel, chromium, silver, molybdenum, and cobalt, or an alloy thereof. Copper is preferably used for the metal plate 2 from the viewpoint of bonding the metal plate 2 to the silicon nitride substrate 1 with a silver-copper-based brazing material containing an active metal or from the viewpoint of conductivity and heat dissipation.

When a copper plate is used, a purity thereof is preferably 90% or more. When the purity is 90% or more, the silicon nitride-metal composite 10 having sufficient conductivity and heat dissipation is obtained, and reaction between the copper plate and the brazing material proceeds sufficiently at the time of bonding the silicon nitride substrate 1 and the copper plate, such that the silicon nitride-metal composite 10 having a high reliability can be obtained.

A thickness of the metal plate 2 is not limited, and is generally 0.1 mm or more and 1.5 mm or less. Furthermore, the thickness of the metal plate 2 is preferably 0.2 mm or more from the viewpoint of heat dissipation, and preferably 0.5 mm or less from the viewpoint of thermal-resistant cycle characteristics.

### (Brazing Material)

From the viewpoint of improving the thermal-resistant cycle characteristics, the brazing material used for the silicon nitride-metal composite 10 according to the present embodiment preferably contains Ag, Cu and Ti, and either Sn or In, or both Sn and In.

More preferably, the brazing material contains 78.5 parts by mass or more and 95 parts by mass or less of Ag, 5.0 parts by mass or more and 13 parts by mass or less of Cu, 1.5 parts by mass or more and 5.0 parts by mass or less of Ti, and 0.4 parts by mass or more and 3.5 parts by mass or less a total amount of Sn and In, with respect to a total of 100 parts by mass of Ag, Cu, Ti, and Sn and In.

With the embodiment, the silicon nitride-metal composite 10 having higher reliability can be achieved.

Ag powder having a specific surface area of 0.1 m²/g or more and 0.5 m²/g or less may be used as Ag described above. By using the Ag powder having an appropriate specific surface area, it is possible to sufficiently reduce aggregation of the powder, bonding defects, formation of bonding voids, or the like. A gas adsorption method can be applied to measurement of the specific surface area.

The Ag powder is generally produced by an atomizing method, a wet reduction method, or the like.

As Cu described above, Cu powder having a specific surface area of 0.1 m²/g or more and 1.0 m²/g or less and a median diameter D50 of 0.8 um or more and 8.0 um or less in a particle size distribution on a volume basis measured by a laser diffraction method, may be used, in order to make the Ag-rich phases continuous . By using the Cu powder with the appropriate specific surface area or grain size, it is possible to reduce the bonding defects and suppress the Ag-rich phases from being discontinuous due to the Cu-rich phase.

Sn or In contained in the brazing material powder is a component for reducing a contact angle of the brazing material with respect to the silicon nitride substrate 1 and improving wettability of the brazing material. The blending amount thereof is preferably 0.4 parts by mass or more and 3.5 parts by mass or less with respect to a total of 100 parts by mass of Ag and Cu.

By appropriately adjusting the blending amount, the wettability to the silicon nitride substrate 1 can be made appropriate and the possibility of bonding defects can be reduced. In addition, it is possible to suppress the Ag-rich phases in the brazing material layer 3 to be discontinuous due to the Cu-rich phase, to reduce an origin of cracking of the brazing material, and to reduce the possibility of decreasing in thermal cycle characteristics.

As Sn or In described above, Sn or In powder having a specific surface area of 0.1 m²/g or more and 1.0 m²/g or less and D50 of 0.8 um or more and 10.0 um or less may be used.

By using powder with the appropriate specific surface area or grain size, it is possible to reduce the possibility of bonding defects or the possibility of occurrence of bonding voids.

The brazing material preferably contains an active metal from the viewpoint of enhancing reactivity with the silicon nitride substrate. Specifically, it is preferable to contain titanium because it can have high reactivity with the silicon nitride substrate 1 and a very high bonding strength.

An addition amount of the active metal such as titanium is preferably 1.5 parts by mass or more and 5.0 parts by mass or less, with respect to the total of 100 parts by mass of the Ag powder, the Cu powder, and the Sn powder or the In powder. By appropriately adjusting the addition amount of the active metal, the wettability to the silicon nitride substrate 1 can be further enhanced, and the occurrence of bonding defects can be further reduced. In addition, the unreacted active metal can be reduced to remain, and discontinuity of the Ag-rich phases can also be reduced.

The brazing material paste may be obtained by mixing at least the above-described metal powder with an organic solvent or an organic binder, if necessary. For mixing, a mortar machine, a rotation-revolution mixer, a planetary mixer, a triple roller, or the like may be used. As a result, a paste-like brazing material can be obtained, for example.

The organic solvent that is available here is not limited. Examples of the organic solvent may include methyl cellosolve, ethyl cellosolve, isophorone, toluene, ethyl acetate, telepineol, diethylene glycol monobutyl ether, and texanol.

The organic binder that is available here is not limited. Examples of the binder may include a polymer compound such as polyisobutyl methacrylate, ethyl cellulose, methyl cellulose, an acrylic resin, and a methacrylic resin.

### (Brazing Material Paste Application)

A method of applying the brazing material paste to the silicon nitride substrate 1 in (1) is not limited. Examples of the method of applying the brazing material paste may include a roll coater method, a screen printing method, a transfer method, and the like. The screen printing method is preferable because it is easy to uniformly apply the brazing material paste.

In order to uniformly apply the brazing material paste by the screen printing method, a viscosity of the brazing material paste is preferably controlled to 5 Pa·s or more and 20 Pa·s or less. In addition, an amount of the organic solvent in the brazing material paste is adjusted to, for example, 5% by mass or more and 17% by mass or less, and an amount of the organic binder is adjusted to, for example, 2% by mass or more and 8% by mass or less, such that printability can be enhanced.

### (Bonding)

A treatment of the bonding of the silicon nitride substrate 1 and the metal plate 2 in the (2) is preferably performed in a vacuum or inert atmosphere such as nitrogen or argon at a temperature of 740°C or higher and 850°C or lower for 10 minutes or longer and 60 minutes or shorter.

When the temperature is 740°C or higher, when the treatment time is 10 minutes or longer, or when both conditions that both the temperature is 740°C or higher and the treatment time is 10 minutes or longer are satisfied, for example, when the metal plate 2 is a copper plate, an amount of copper dissolved from the copper plate can be sufficiently increased and bondability of the silicon nitride substrate 1 and the metal plate 2 can be sufficiently strengthened.

On the other hand, when the temperature is 850°C or lower, when the treatment time is 60 minutes or shorter, or when both conditions that the temperature is 850°C or lower and the treatment time is 60 minutes or shorter are satisfied, merits, such as maintenance of continuity of the Ag-rich phases in the obtainable brazing material layer, for example, reduction of diffusion of excessive brazing material into the copper plate when the metal plate 2 is a copper plate, reduction of coarsening of the copper crystal due to recrystallization of copper, and reduction in stress resulting from a difference in coefficient of thermal expansion between ceramic and copper, can be obtained.

The silicon nitride-metal composite 10 is obtainable by the steps such as (1) and (2) described above. By using the silicon nitride substrate 1 according to the present embodiment, warpage of the silicon nitride substrate 1 can be reduced, and thus reliability of bonding between the silicon nitride substrate 1 and the metal plate 2 can be improved, and deformation of the silicon nitride substrate 1 or accumulation of thermal stress in the producing process of the silicon nitride-metal composite 10 can be reduced, such that it is considered that the yield is improved.

### <Silicon Nitride Circuit Board>

The obtained silicon nitride-metal composite 10 may be further treated, processed, or treated and processed to obtain a silicon nitride circuit board. For example, at least a part of the metal plate 2 of the silicon nitride-metal composite 10 may be removed to form a circuit. More specifically, a circuit pattern may be formed by removing a part of the metal plate 2 or the brazing material layer 3 by etching. As a result, a silicon nitride circuit board is obtainable.

A procedure for forming the circuit pattern on the silicon nitride-metal composite 10 to obtain a silicon nitride circuit board will be described below.

### • Formation of Etching Mask

First, an etching mask is formed on a surface of the metal plate 2.

As a method of forming the etching mask, a known technology, such as a photographic development method (photoresist method), a screen printing method, or an inkjet printing method using, for example, PER400K ink (produced by Goo Chemical Co., Ltd.), may be appropriately adopted.

### • Etching Treatment of Metal Plate 2

In order to form the circuit pattern, an etching treatment is performed on the metal plate 2.

There is no limitation on an etching solution. As the etching solution generally used, a ferric chloride solution, a cupric chloride solution, a sulfuric acid, a hydrogen peroxide solution, or the like may be used. Preferred examples thereof may include a ferric chloride solution or a cupric chloride solution. A side surface of a copper circuit may be tilted by adjusting an etching time.

### • Etching Treatment of Brazing Material Layer 3

The applied brazing material, an alloy layer thereof, a nitride layer, and the like remain in the silicon nitride-metal composite from which a part of the metal plate 2 is removed by etching. Therefore, it is common to remove them by using a solution containing an aqueous solution of ammonium halide, inorganic acids such as sulfuric acid and nitric acid, or a hydrogen peroxide solution. By adjusting conditions such as an etching time, a temperature, and a spray pressure, a length and a thickness of the protruding portion of the brazing material can be adjusted.

### • Peeling of Etching Mask

A method of peeling the etching mask after the etching treatment is not limited. A method of immersing the etching mask in an alkaline aqueous solution is generally used.

### • Plating/Rustproofing Treatment

From the viewpoint of improving durability, decreasing changes over time, or the like, a plating treatment or a rustproofing treatment may be performed.

Examples of the plating may include Ni plating, Ni alloy plating, Au plating, and the like. A specific method of plating may be performed by, for example, (i) a normal electroless plating method of using a liquid chemical containing a hypophosphorous acid salt as a Ni-P electroless plating liquid after degreasing, chemical polishing, and a pretreatment step with a liquid chemical for Pd activation, and (ii) a method of electroplating by bringing an electrode into contact with a copper circuit pattern.

The rustproofing treatment may be performed by, for example, a benzotriazole-based compound.

### <Semiconductor Package>

A semiconductor package such as a power module or the like is obtainable by disposing an appropriate semiconductor element on the silicon nitride circuit board on which the circuit is formed as described above, for example.

For specific configurations and details of the power module, see, for example, Patent Documents 1 to 3 described above, Japanese Unexamined Patent Publication No. H10-223809, Japanese Unexamined Patent Publication No. H10-214915, and the like.

Although the embodiments of the present invention have been described above, these are mere examples of the present invention, and various other configurations other than those given above may be adopted. Further, the present invention is not limited to the above-described embodiments, and modifications, improvements, and the like within the range in which the object of the present invention can be achieved are included in the present invention.

### [Examples]

Embodiments of the present invention will be described in detail based on Examples and Comparative Examples. The present invention is not limited to Examples.

### [Example 1]

### <Raw Material Mixing>

Si₃N₄ powder and SiO₂ powder, MgO powder, and Y₂O₃ powder which are sintering aids were prepared and weighed so as to have blending amounts shown in Table 1. Then, the mixed powder, an organic solvent, and a silicon nitride ball as a pulverizing medium were put into a resin pot of a ball mill, and wet-mixed. In addition, an organic binder (20 parts by mass with respect to a total of 100 parts by mass of raw material powder) was added to the mixture and wet-mixed to obtain a sheet molding slurry.

The raw material powder used is as shown below.
Si₃N₄ powder: product number SN-9FWS produced by Denka Company Limited, average particle size (D50) 0.7 um
SiO₂ powder: product number SFP-30M produced by Denka Company Limited, average particle size (D50) 0.6 um
MgO powder: product number MTK-30 produced by Iwatani Chemical Industry Co., Ltd., average particle size (D50) 0.2 um
Y₂O₃ powder: product name: spherical fine powder, produced by Shin-Etsu Chemical Co., Ltd., average particle size (D50) 1.0 um

### <Sheet Molding>

The obtained sheet molding slurry was defoamed, a viscosity was adjusted by removing the solvent, and the sheet was molded by a doctor blade method. In addition, the molded sheet was punched to obtain a punched sheet. A size of the punched sheet was adjusted so that a size of the silicon nitride substrate after firing was 148 mm × 200 mm × 0.32 mm.

### <BN Application>

In order to apply BN to an upper surface (one surface) of the above-described sheet, a BN slurry containing BN powder and an organic solvent was prepared. In addition, the BN slurry was applied to one surface of the sheet by a coater method or a screening method and dried to obtain a BN-applied sheet.

### <Degreasing>

60 BN-applied sheets were stacked and the stack was heated in an atmosphere (atmosphere containing oxygen), such that the organic binder was degreased (removed) to obtain a degreased body.

Temperature conditions for degreasing are as shown below.
Retention Temperature: 500°C
Retention Time: 10 hours

### <Firing>

The obtained 60 stacked degreased bodies (2,040 g) were installed in a container formed of BN (BN container). The BN container was composed of a frame, a lower lid, and an upper lid, and had a structure including a space in which a lower frame and the frame, and the frame and the upper lid are fitted to be closed by installing the lower lid, the frame, and the upper lid in this order from below, and a volume of the BN container is 5,544 cm³. 100 g of a silicon nitride substrate (sintered body) for adjusting atmosphere was installed in the BN container together with the degreased body. The silicon nitride substrate was installed in a direction perpendicular to the degreased body (direction parallel to the frame of the BN container) . The BN container in which the degreased body and the silicon nitride substrate were housed was put into the firing furnace and fired.

Firing conditions are as shown below.
Retention Temperature: 1,850°C
Retention Time: 5 hours
Temperature lowering rate (1,850 to 1,400°C): 0.8°C/min
Temperature lowering rate (1,400°C or less): 6°C/min
Atmosphere: nitrogen atmosphere (0.88 MPa, gas flow rate: 30 L/min)

Through the above steps, a silicon nitride substrate having a size of 148 mm × 200 mm × 0.32 mm was obtained.

### <Evaluation Method>

The obtained silicon nitride substrates of Examples and Comparative Examples were evaluated by the following methods.

### (Analysis by X-ray fluorescence analysis)

An intersection of diagonals on a surface of the silicon nitride substrates of Examples and Comparative Examples was defined as an intersection A, and composition analysis was performed with an X-ray fluorescence spectrometer while centering on the intersection A.

In addition, the composition analysis was performed with an X-ray fluorescence spectrometer while centering on four points B1, B2, B3, and B4 which are positioned 3 mm inward from corners of the silicon nitride substrate to a direction of the intersection A and present on the two diagonals on the surface of the silicon nitride substrate.

Conditions of analysis by the X-ray fluorescence analysis are as described above.
Measuring device: ZSX100e manufactured by Rigaku Corporation
X-ray tube power: 3.6 kW
Spot diameter: 1 mm

As a quantifying method, a fundamental parameter (FP) method was adopted. Assuming that all of silicon are present as nitride (Si₃N₄), silicon nitride (Si₃N₄) was calculated as a balance component so that the total of each component is 100%. In addition, assuming that magnesium and yttrium are present as oxides, respectively, the magnesium and the yttrium were calculated in terms of magnesium oxide (MgO) and yttrium oxide (Y₂O₃) .

An amount of magnesium in A (% by mass, in terms of oxide) was defined as XA (%), an amount of magnesium in B1, B2, B3, B4 (% by mass, in terms of oxide) was defined as XB1 (%), XB2 (%), XB3 (%), and XB4 (%), and an arithmetic mean value of XB1 (%), XB2 (%), XB3 (%), and XB4 (%) was defined as XB (%).

An amount of yttrium in A (% by mass, in terms of oxide) was defined as YA (%), an amount of yttrium in B1, B2, B3, B4 (% by mass, in terms of oxide) was defined as YB1 (%), YB2 (%), YB3 (%), and YB4 (%), and an arithmetic mean value of YB1 (%), YB2 (%), YB3 (%), and YB4 (%) was defined as YB (%).

In addition, XB/XA and YA/YB were calculated.

The results are shown in Table 1.

### (Analysis by Oxygen/Nitrogen Analyzer)

From the silicon nitride substrates of Examples and Comparative Examples, a square having a side of 3 mm centered on the intersection of diagonals on the surface of the silicon nitride substrate was cut out to obtain a sample C for oxygen analysis. The sample C for oxygen analysis was analyzed with an oxygen-nitrogen analyzer, and an oxygen concentration (% by mass) of the sample C for oxygen analysis was defined as ZC (%). In addition, a square having a side of 3 mm including the corners was cut out from the silicon nitride substrates of Examples and Comparative Examples, and is used as a sample D for oxygen analysis. The sample D for oxygen analysis was analyzed with an oxygen-nitrogen analyzer, and an oxygen concentration (% by mass) of the sample D for oxygen analysis was defined as ZD (%) . EMGA-920 manufactured by HORIBA, Ltd was used as an oxygen-nitrogen analyzer.

The results are shown in Table 1.

### (Warpage Measurement)

Warpage of the silicon nitride substrates of Examples and Comparative Examples was measured with a three-dimensional laser measuring instrument manufactured by KEYENCE CORPORATION.
Measurement software model number: KS-Measure KS-H1M
Analysis software model number: KS-Analyzer KS-H1A

A difference in height between the minimum point and the maximum point in the surface of the silicon nitride substrate was defined as an amount of warpage (um), the difference in height obtained by horizontally installing each of the silicon nitride substrates of Examples and Comparative Examples, and scanning the entire surface of the silicon nitride substrate of 148 mm × 200 mm with intervals of 1 mm, a value obtained by dividing the amount of warpage (um) by a length (mm) of the diagonal was defined as warpage (pm/mm) per unit length, thereby performing estimation based on the following criteria.
∘: The amount of warpage per unit length is less than 2.0 pm/mm
×: The amount of warpage per unit length is 2.0 pm/mm or more.

Warpage was evaluated for 60 silicon nitride substrates fired at the same time, and a yield was calculated when o was regarded as acceptable and × was evaluated as unacceptable. The results are shown in Table 1.

In addition, a fracture toughness value of the silicon nitride substrate of Example 1 was measured. As a result of measuring the fracture toughness values for the three substrates A to C at the central portion of the substrate (region within a radius of 3 mm centered on the intersection of the diagonals) and the outer peripheral portion of the substrate (region within a radius of 3 mm from the corners), the central portion of the substrate A was 6.6 Mpa/m^{1/2}, the outer peripheral portion of the substrate A was 6.7 Mpa/m^{1/2}, the central portion of the substrate B was 6.8 Mpa/m^{1/2}, the outer peripheral portion of the substrate B was 6.9 Mpa/m^{1/2}, the central portion of the substrate C was 6.8 Mpa/m^{1/2}, and the outer peripheral portion of the substrate C was 6.7 Mpa/m^{1/2}, and it was thus confirmed that variations in mechanical properties in the plurality of silicon nitride substrates of Example 1 fired at the same time were reduced and an in-plane distribution of mechanical properties in one silicon nitride substrate was reduced.

The fracture toughness was measured by an IF method based on JIS-R1607. That is, an indentation generated by pressing a Vickers indenter into a test surface and a crack length were measured, and the fracture toughness value was calculated from an indentation load, a diagonal length of the indentation, the crack length, a modulus of elasticity. The indentation load was 2 kgf (19.6 N).

### [Examples 2 to 4]

A silicon nitride substrate was produced in the same manner as in Example 1 except for the raw material blending ratio as shown in Table 1, and analysis by X-ray fluorescence analysis, analysis by an oxygen/nitrogen analyzer, and warpage measurement were performed.

The results are shown in Table 1.

### [Comparative Example 1]

A silicon nitride substrate was produced in the same manner as in Example 1 except that the temperature lowering rate from 1,850°C to 1, 400°C in the firing was 8°C/min and the silicon nitride substrate for adjusting atmosphere was not installed in the BN container, and analysis by X-ray fluorescence analysis, analysis by an oxygen/nitrogen analyzer, and warpage measurement were performed.

The results are shown in Table 1.

### [Comparative Example 2]

A silicon nitride substrate was produced in the same manner as in Example 1 except that the silicon nitride substrate for adjusting atmosphere was not installed in the BN container in the firing, and analysis by X-ray fluorescence analysis, analysis by an oxygen/nitrogen analyzer, and warpage measurement were performed.

The results are shown in Table 1.

As understood from each Example and Comparative Example, in the example in which the temperature lowering rate in the high-temperature region and a firing atmosphere were optimized, it was possible to control XB/XA to 0.80 or more and 1.00 or less and to obtain the silicon nitride substrate with a high yield and reduced warpage though the silicon nitride substrate had a relatively large size of 148 mm × 200 mm. On the other hand, in the comparative example in which the temperature lowering rate and the firing atmosphere were not adjusted, it was not possible to control XB/XA to 0.80 or more and 1.00 or less and not possible to obtain a silicon nitride substrate with a high yield and reduced warpage.

**[Table 1]**

| | | | | | Example 1 | Example 2 | Example 3 | Example 4 | Comparative Example 1 | Comparative Example 2 |
|---|---|---|---|---|---|---|---|---|---|---|
| Sheet | Raw Material Blending Ratio/wt% | Si₃N₄ | | | 92.5 | 91.4 | 93.7 | 91.4 | 92.5 | 92.5 |
| | | SiO₂ | | | 0.5 | 1.1 | 1.3 | 1.6 | 0.5 | 0.5 |
| | | Y₂O₃ | | | 5.0 | 6.0 | 3.0 | 5.0 | 5.0 | 5.0 |
| | | MgO | | | 2.0 | 1.5 | 2.0 | 2.0 | 2.0 | 2.0 |
| Firing Condition | Cooling Rate °C/min | | | | 0.8 | 0.8 | 0.8 | 0.8 | 8 | 0.8 |
| | Presence or Absence of Atmosphere Adjuster | | | | Present | Present | Present | Present | Absent | Absent |
| | Substrate Size/mm | | | | 148 × 200 | 148 × 200 | 148 × 200 | 148 × 200 | 148 × 200 | 148 × 200 |
| | Substrate Thickness/mm | | | | 0.32 | 0.32 | 0.32 | 0.32 | 0.32 | 0.32 |
| | Analysis Result by X-ray Fluorescence Analysis/% by mass | Si₃N₄ | Substrate Central Portion A | | 92.8 | 92.2 | 94.7 | 92.5 | 92.8 | 92.8 |
| | | | Substrate Outer Peripheral Portion B | | 92.8 | 92.1 | 94.7 | 92.4 | 92.9 | 92.9 |
| | | Y (in terms of Y₂O₃) | Substrate Central Portion A | YA | 5.09 | 6.40 | 3.02 | 5.19 | 5.09 | 5.11 |
| | | | Substrate Outer Peripheral Portion B | YB | 5.16 | 6.52 | 3.23 | 5.35 | 5.34 | 5.28 |
| | | Mg (in terms of MgO) | Substrate Central Portion A | XA | 1.79 | 1.15 | 1.95 | 1.96 | 1.75 | 1.76 |
| Silicon Nitride Substrate | | | Substrate Outer Peripheral Portion B | XB | 1.68 | 1.01 | 1.67 | 1.77 | 1.32 | 1.39 |
| | | Others | Substrate Central Portion A | | 0.30 | 0.28 | 0.30 | 0.32 | 0.31 | 0.31 |
| | | | Substrate Outer Peripheral Portion B | | 0.35 | 0.32 | 0.35 | 0.33 | 0.36 | 0.36 |
| | Oxygen-Nitrogen Analysis Result/% by mass | O | Substrate Central Portion C | ZC | 2.43 | 2.82 | 2.79 | 2.98 | 2.60 | 2.61 |
| | | | Substrate Outer Peripheral Portion D | ZD | 2.36 | 2.74 | 2.74 | 2.66 | 2.34 | 2.36 |
| | XB/XA | | | | 0.94 | 0.88 | 0.86 | 0.90 | 0.75 | 0.79 |
| | YA/YB | | | | 0.99 | 0.98 | 0.93 | 0.97 | 0.95 | 0.97 |
| | ZD/ZC | | | | 0.97 | 0.97 | 0.98 | 0.89 | 0.90 | 0.90 |
| | Warpage Yield/% | | | | 100% | 100% | 95% | 92% | 22% | 47% |

### REFERENCE SIGNS LIST

1: silicon nitride substrate
2: metal plate
3: brazing material layer

## Claims

1. A silicon nitride substrate (1) comprising silicon nitride and magnesium,
wherein the silicon nitride substrate (1) has a rectangular shape and the diagonal on the surface of the silicon nitride substrate (1) has a length of 150 mm or more, and
when a surface of the silicon nitride substrate (1) is analyzed with an X-ray fluorescence spectrometer under the following Condition I, XB/XA is 0.80 or more and 1.00 or less,
(Condition I)
an amount of magnesium, in % by mass in terms of oxide, at an intersection A of diagonals on any one surface of the silicon nitride substrate (1) is defined as XA, the amount of magnesium obtained by analyzing the intersection A with the X-ray fluorescence spectrometer, and an arithmetic mean value of amounts of magnesium, in % by mass in terms of oxide, at four points of B1, B2, B3, and B4 which are on the diagonals and positioned 3 mm inward from corners of the silicon nitride substrate (1) to a direction of the intersection A is defined as XB, the arithmetic mean value of the amounts of magnesium obtained by analyzing the four points B1, B2, B3, and B4 with the X-ray fluorescence spectrometer.

2. The silicon nitride substrate (1) according to claim 1,
wherein when the surface of the silicon nitride substrate (1) is analyzed with the X-ray fluorescence spectrometer under the following Condition II, YA/YB is 0.90 or more and 1.00 or less,
(Condition II)
an amount of yttrium, in % by mass in terms of oxide, at an intersection A of diagonals on any one surface of the silicon nitride substrate (1) is defined as YA, the amount of yttrium obtained by analyzing the intersection A with the X-ray fluorescence spectrometer, and, an arithmetic mean value of amounts of yttrium, in % by mass in terms of oxide, at four points of B1, B2, B3, and B4 which are on the diagonals and positioned 3 mm inward from corners of the silicon nitride substrate (1) to a direction of the intersection A is defined as YB, the arithmetic mean value of the amounts of yttrium obtained by analyzing the four points B1, B2, B3, and B4 with the X-ray fluorescence spectrometer.

3. The silicon nitride substrate (1) according to claim 1 or 2,
wherein when the silicon nitride substrate (1) is analyzed with an oxygen-nitrogen analyzer under the following Condition III, each of ZC and ZD is 0.10% or more and 7.00% or less, and ZD/ZC is 0.85 or more and 1.00 or less,
(Condition III)
a square having a side of 3 mm centered on an intersection of diagonals on the surface of the silicon nitride substrate (1) is cut out from the silicon nitride substrate (1), and is used as a sample C for oxygen analysis,
the sample C for oxygen analysis is analyzed with the oxygen-nitrogen analyzer, and an oxygen concentration, in % by mass, of the sample C for oxygen analysis is defined as ZC,
a square having a side of 3 mm including any corner on the surface of the silicon nitride substrate (1) is cut out from the silicon nitride substrate (1), and is used as a sample D for oxygen analysis, and
the sample D for oxygen analysis is analyzed with an oxygen-nitrogen analyzer, and an oxygen concentration, in % by mass, of the sample D for oxygen analysis is defined as ZD.

4. A silicon nitride-metal composite (10) in which a metal plate (2) is bonded to at least one surface of the silicon nitride substrate (1) according to any one of claims 1 to 3.

5. A silicon nitride circuit board in which at least a part of the metal plate (2) is removed from the silicon nitride-metal composite (10) according to claim 4.

6. A semiconductor package in which a semiconductor element is mounted on the silicon nitride circuit board according to claim 5.

## Patentansprüche

1. Siliziumnitrid-Substrat (1), das Siliziumnitrid und Magnesium umfasst,
wobei das Siliziumnitrid-Substrat (1) eine rechteckige Form hat und die Diagonale auf der Oberfläche des Siliziumnitrid-Substrats (1) eine Länge von 150 mm oder mehr hat, und
wenn eine Oberfläche des Siliziumnitrid-Substrats (1) mit einem Röntgenfluoreszenzspektrometer unter der folgenden Bedingung I analysiert wird, XB/XA 0,80 oder mehr und 1,00 oder weniger beträgt,
(Bedingung I)
eine Menge an Magnesium, in Masse-% bezogen auf Oxid, an einem Schnittpunkt A von Diagonalen auf einer beliebigen Oberfläche des Siliziumnitrid-Substrats (1) ist als XA definiert, wobei die Menge an Magnesium durch Analyse des Schnittpunkts A mit dem Röntgenfluoreszenzspektrometer erhalten wird; und ein arithmetischer Mittelwert von Mengen an Magnesium, in Masse-% bezogen auf Oxid, an vier Punkten B1, B2, B3 und B4, die auf den Diagonalen liegen und 3 mm einwärts von Ecken des Siliziumnitrid-Substrats (1) in Richtung des Schnittpunkts A positioniert sind, ist als XB definiert, wobei der arithmetische Mittelwert der Mengen an Magnesium durch Analyse der vier Punkte B1, B2, B3 und B4 mit dem Röntgenfluoreszenzspektrometer erhalten wird.

2. Siliziumnitrid-Substrat (1) nach Anspruch 1,
wobei, wenn die Oberfläche des Siliziumnitrid-Substrats (1) mit dem Röntgenfluoreszenzspektrometer unter der folgenden Bedingung II analysiert wird, YA/YB 0,90 oder mehr und 1,00 oder weniger beträgt,
(Bedingung II)
eine Menge an Yttrium, in Masse-% bezogen auf Oxid, an einem Schnittpunkt A von Diagonalen auf einer beliebigen Oberfläche des Siliziumnitrid-Substrats (1) ist als YA definiert, wobei die Menge an Yttrium durch Analyse des Schnittpunkts A mit dem Röntgenfluoreszenzspektrometer erhalten wird; und ein arithmetischer Mittelwert von Mengen an Yttrium, in Masse-% bezogen auf Oxid, an vier Punkten B1, B2, B3 und B4, die auf den Diagonalen liegen und 3 mm einwärts von Ecken des Siliziumnitrid-Substrats (1) in Richtung des Schnittpunkts A positioniert sind, ist als YB definiert, wobei der arithmetische Mittelwert der Mengen an Yttrium durch Analyse der vier Punkte B1, B2, B3 und B4 mit dem Röntgenfluoreszenzspektrometer erhalten wird.

3. Siliziumnitrid-Substrat (1) nach Anspruch 1 oder 2,
wobei, wenn das Siliziumnitrid-Substrat (1) mit einem Sauerstoff-Stickstoff-Analysator unter der folgenden Bedingung III analysiert wird, ZC und ZD jeweils 0,10 % oder mehr und 7,00 % oder weniger betragen und ZD/ZC 0,85 oder mehr und 1,00 oder weniger beträgt,
(Bedingung III)
aus dem Siliziumnitrid-Substrat (1) wird ein Quadrat mit einer Seitenlänge von 3 mm ausgeschnitten, das auf einem Schnittpunkt von Diagonalen auf der Oberfläche des Siliziumnitrid-Substrats (1) zentriert ist, und wird als Probe C für die Sauerstoffanalyse verwendet,
die Probe C für die Sauerstoffanalyse wird mit dem Sauerstoff-Stickstoff-Analysator analysiert, und eine Sauerstoffkonzentration, in Masse-%, der Probe C für die Sauerstoffanalyse wird als ZC definiert,
aus dem Siliziumnitrid-Substrat (1) wird ein Quadrat mit einer Seite von 3 mm, das eine beliebige Ecke auf der Oberfläche des Siliziumnitrid-Substrats (1) umfasst, herausgeschnitten und wird als Probe D für die Sauerstoffanalyse verwendet, und
die Probe D für die Sauerstoffanalyse wird mit einem Sauerstoff-Stickstoff-Analysator analysiert, und die Sauerstoffkonzentration, in Masse-%, der Probe D für die Sauerstoffanalyse wird als ZD definiert.

4. Siliziumnitrid-Metall-Verbund (10), bei dem eine Metallplatte (2) mit mindestens einer Oberfläche des Siliziumnitrid-Substrats (1) nach einem der Ansprüche 1 bis 3 verbunden ist.

5. Siliziumnitrid-Leiterplatte, bei der zumindest ein Teil der Metallplatte (2) aus dem Siliziumnitrid-Metall-Verbund (10) nach Anspruch 4 entfernt ist.

6. Halbleitergehäuse, bei dem ein Halbleiterelement auf der Siliziumnitrid-Leiterplatte nach Anspruch 5 montiert ist.

## Revendications

1. Substrat de nitrure de silicium (1) comprenant du nitrure de silicium et du magnésium,
dans lequel le substrat de nitrure de silicium (1) a une forme rectangulaire et la diagonale sur la surface du substrat de nitrure de silicium (1) a une longueur de 150 mm ou plus, et
lorsqu'une surface du substrat de nitrure de silicium (1) est analysée à l'aide d'un spectromètre de fluorescence à rayons X sous la condition I suivante, XB/XA est égal ou supérieur à 0,80 et inférieur ou égal à 1,00,
(Condition I)
une quantité de magnésium, en % de masse en termes d'oxyde, à une intersection A de diagonales sur une surface quelconque du substrat de nitrure de silicium (1) est définie comme XA, la quantité de magnésium obtenue en analysant l'intersection A avec le spectromètre de fluorescence à rayons X, et une valeur moyenne arithmétique des quantités de magnésium, en % de masse en termes d'oxyde, en quatre points de B1, B2, B3 et B4 situés sur les diagonales et positionnés à 3 mm des coins du substrat en nitrure de silicium (1) dans la direction de l'intersection A est définie comme XB, la valeur moyenne arithmétique des quantités de magnésium obtenues en analysant les quatre points B1, B2, B3 et B4 à l'aide du spectromètre de fluorescence à rayons X.

2. Substrat de nitrure de silicium (1) selon la revendication 1,
dans lequel, lorsque la surface du substrat de nitrure de silicium (1) est analysée à l'aide du spectromètre de fluorescence à rayons X dans les conditions II suivantes, YA/YB est égal ou supérieur à 0,90 et inférieur ou égal à 1,00,
(Condition II)
une quantité d'yttrium, en % de masse en termes d'oxyde, à une intersection A de diagonales sur une surface quelconque du substrat de nitrure de silicium (1) est définie comme YA, la quantité d'yttrium obtenue en analysant l'intersection A avec le spectromètre de fluorescence à rayons X, et, une valeur moyenne arithmétique des quantités d'yttrium, en % de masse en termes d'oxyde, en quatre points de B1, B2, B3 et B4 situés sur les diagonales et positionnés à 3 mm des coins du substrat en nitrure de silicium (1) dans la direction de l'intersection A est définie comme YB, la valeur moyenne arithmétique des quantités d'yttrium obtenues en analysant les quatre points B1, B2, B3 et B4 à l'aide du spectromètre de fluorescence à rayons X.

3. Substrat de nitrure de silicium (1) selon la revendication 1 ou 2,
dans lequel, lorsque le substrat de nitrure de silicium (1) est analysé à l'aide d'un analyseur d'oxygène et d'azote dans la condition III suivante, ZC et ZD sont égaux ou supérieurs à 0,10 % et égaux ou inférieurs à 7,00 %, et ZD/ZC sont égaux ou supérieurs à 0,85 et égaux ou inférieurs à 1,00,
(Condition III)
un carré de 3 mm de côté centré sur une intersection de diagonales à la surface du substrat de nitrure de silicium (1) est découpé dans le substrat de nitrure de silicium (1) et est utilisé comme échantillon C pour l'analyse de l'oxygène,
l'échantillon C destiné à l'analyse de l'oxygène est analysé à l'aide de l'analyseur d'oxygène et d'azote, et la concentration d'oxygène, en % de masse, de l'échantillon C destiné à l'analyse de l'oxygène est définie comme ZC,
un carré d'un côté de 3 mm, y compris tout coin sur la surface du substrat de nitrure de silicium (1), est découpé dans le substrat de nitrure de silicium (1) et est utilisé comme échantillon D pour l'analyse de l'oxygène, et
l'échantillon D destiné à l'analyse de l'oxygène est analysé à l'aide d'un analyseur d'oxygène et d'azote, et la concentration d'oxygène, en % en masse, de l'échantillon D destiné à l'analyse de l'oxygène est définie comme ZD.

4. Composite nitrure de silicium-métal (10) dans lequel une plaque métallique (2) est collée à au moins une surface du substrat de nitrure de silicium (1) selon l'une quelconque des revendications 1 à 3.

5. Carte de circuit imprimé en nitrure de silicium dans lequel au moins une partie de la plaque métallique (2) est retirée du composite nitrure de silicium-métal (10) selon la revendication 4.

6. Boîtier semi-conducteur dans lequel un élément semi-conducteur est monté sur la carte de circuit imprimé en nitrure de silicium selon la revendication 5.
